Europäisches Patentamt

European Patent Office

Office européen des brevets

(19)

(11) Veröffentlichungsnummer: **0 134 187**
**B1**

(12) # EUROPÄISCHE PATENTSCHRIFT

(45) Veröffentlichungstag der Patentschrift:
**22.04.87**

(21) Anmeldenummer: **84730078.7**

(22) Anmeldetag: **19.07.84**

(51) Int. Cl.⁴: **G 01 R 31/32,** G 01 R 15/06,
H 02 B 13/02, G 01 R 31/12

(54) **Messvorrichtung zur Feststellung von Teilentladungen innerhalb metallgekapselter, druckgasisolierter Hochspannungsschaltanlagen.**

(30) Priorität: **29.07.83 DE 3327917**

(43) Veröffentlichungstag der Anmeldung:
**13.03.85 Patentblatt 85/11**

(45) Bekanntmachung des Hinweises auf die Patenterteilung:
**22.04.87 Patentblatt 87/17**

(84) Benannte Vertragsstaaten:
**CH DE LI**

(56) Entgegenhaltungen:
**FR - A - 2 231 041**
**US - A - 3 939 412**
**US - A - 4 277 746**

(73) Patentinhaber: **Siemens Aktiengesellschaft Berlin und München, Wittelsbacherplatz 2, D-8000 München 2 (DE)**

(72) Erfinder: **Reinhardt, Hans-Jürgen, Dr. Dipl.-Ing., Schillerstrasse 110a, D-1000 Berlin 12 (DE)**

## Beschreibung

Die Erfindung bezieht sich auf eine Messvorrichtung zur Feststellung von Teilentladungen innerhalb metallgekapselter, druckgasisolierter Hochspannungsschaltanlagen mit Hilfe eines kapazitiven Spannungsteilers, dessen Hochspannungskondensator von dem in der Kapselung isoliert abgestützten Innenleiter und einer isoliert mit Abstand in einer Öffnung der Kapselung angeordneten Elektrode und deren Niederspannungskondensator von der Elektrode und dem Rand der Öffnung in der Kapselung gebildet wird und der über eine Messleitung mit einem Anzeige- und/oder Messgerät verbunden ist.

Eine derartige Messvorrichtung ist aus der DE-AS 23 56 160 bekannt. Bei der bekannten Messvorrichtung ist der den Innenleiter abstützende Isolator durch eine Öffnung in der metallischen Kapselung nach aussen geführt, und die Elektrode ist auf der äusseren Mantelfläche oder innerhalb des Isolators im Bereich der Öffnung in der Kapselung koaxial zum Innenleiter angeordnet. Als Anzeige- bzw. Messgerät für die Erfassung von Koronaentladungen, für welche die bekannte Messvorrichtung eingesetzt wird, sind Sprühentladungsdetektoren bzw. Oszillographen verwendet, die zwischen eine äussere Anschlussleitung zur Elektrode und der Erdung der metallischen Kapselung geschaltet sind. Da die zu messenden Koronaentladungen verhältnismässig leistungsstark sind, ist die Tatsache, dass die Kapazität des Hochspannungskondensators $C_H$ gegenüber der des Niederspannungskondensators $C_N$ verhältnismässig klein ist, für die Messung nicht nachteilig.

Der Erfindung liegt dagegen die Aufgabe zugrunde, mit Hilfe der Auskoppelung durch einen kapazitiven Spannungsteiler örtlich begrenzte Teilentladungen zu messen, wobei die Auskoppelung der Teilentladungsimpulse eine hohe Grenzfrequenz im Megaherzbereich aufweisen soll bei einem grossen Teilerverhältnis $C_H(C_H+C_N)$, da die Anstiegszeiten dieser Impulse sehr klein sind und man aber trotzdem eine getreue Impulswiedergabe erzielen will.

Zur Lösung dieser Aufgabe wird eine Messvorrichtung der eingangs beschriebenen Art gemäss der Erfindung so ausgebildet, dass die Elektrode plattenförmig ausgebildet und bündig in die Öffnung der Kapselung eingesetzt ist, dass die Messleitung koaxial ausgebildet ist und mit einem Anschlussteil verbunden ist, der als tragendes Bauteil mit einem Befestigungsflansch die Verbindung zur Kapselung herstellt und die Elektrode und den Rand der Öffnung in der Kapselung enthält, dass der Anschlussteil einen zum Rand der Öffnung in der Kapselung geführten äusseren hohlkegelförmigen Verbindungsteil enthält, die koaxial angeordnet sind, deren Durchmesserverhältnis $d_a/d_i$ konstant ist, und die den Wellenwiderstand der Messleitung aufweisen.

Diese Gestaltung eines Anschlussteiles als tragendes Bauteil, das die plattenförmige, bündig zur Kapselungsinnenwand angeordnete Elektrode trägt, erlaubt einerseits die Beibehaltung der Abmessungen der Kapselung, ohne dass durch die Messvorrichtung eine Beeinträchtigung der Spannungsfestigkeit auftritt und andererseits einen besonders einfachen Einbau. Weiterhin wird praktisch durch die kegelförmige Ausbildung der Verbindungsteile innerhalb des Anschlusteiles die zu den die Niederspannungskapazität bildenden Teile, die Elektrode und der Rand der Öffnungen der Kapselung, führen und den Wellenwiderstand der koaxialen Messleitung aufweisen, ein Verhalten der Messvorrichtung erreicht, als ob die koaxiale Messleitung bis unmittelbar an die Kondensatorelektroden geführt ist. Dadurch treten keine Reflexionen oder störenden Überlagerungen der zu messenden Impulse der Teilentladungen innerhalb der Messvorrichtung auf. Weiterhin kann die Kapazität des Niederspannungskondensators im Verhältnis zu der gegebenen des Hochspannungskondensators durch die Wahl der Abmessungen der plattenförmigen Elektrode und des sie umgebenden Spaltes zum Rand der Öffnung in der Kapselung verhältnismässig klein ausgebildet werden, was das Teilerverhältnis verbessert. Der Durchmesser der plattenförmigen Elektrode kann so gewählt werden, dass die gewünschte hohe Grenzfrequenz erreicht wird. Die Impulswiedergabe wird daher nicht wesentlich verfälscht.

Zur weiteren fertigungstechnischen Erleichterung ist es für die Gestaltung des Anschlusteiles günstiger, dass der Befestigungsflansch des Anschlusteiles an einen räumlich vom Rand der Öffnung in der Kapselung getrennten Flansch der Kapselung befestigt ist und dass dann zwischen dem äusseren Verbindungsteil und dem Flansch der Kapselung mindestens zwei leitende Verbindungen vorgesehen sind, die in der axialen Richtung des Innenleiters angerodnet sind und bündig zur Innenwand der Kapselung liegen. Dadurch wird eine direkte grossflächige leitende Verbindung zwischen der durch den Rand der Öffnung in der Kapselung gebildeten Elektrode des Niederspannungskondensators und dem räumlich getrennten Flansch der Kapselung gebildet, die eine einwandfreie Potentialanbindung an die Kapselung erlaubt. Als leitende Verbindung empfiehlt sich die Verwendung von flexiblen Bändern aus leitfähigem Material, insbesondere aus Kupfer. Dadurch wird eine Verfälschung der ausgekoppelten Impulse der Teilentladungen vermieden.

Die plattenförmige Elektrode wird mit Vorteil aus Ausschnitt der den Innenleiter koaxial umgebenden Kapselung gewählt. Da diese meist als koaxialer Zylinder ausgebildet ist und die normalen in der Kapselung vorhandenen Anschlussöffnungen kreisförmig gestaltet sind, empfiehlt sich auch für die Elektrode ein kreisförmiger Ausschnitt. Zur einfacheren Fertigung und Montage wird die Elektrode als ebene Platte gestaltet und bündig tangential am tiefsten Punkt des Zylinderausschnitts angeordnet.

Der Rand der Elektrode und der gegenüberstehende Rand der Öffnung in der Kapselung können flanschartig nach aussen gezogen sein, um das Teilverhältnis wahlfrei einstellen zu können.

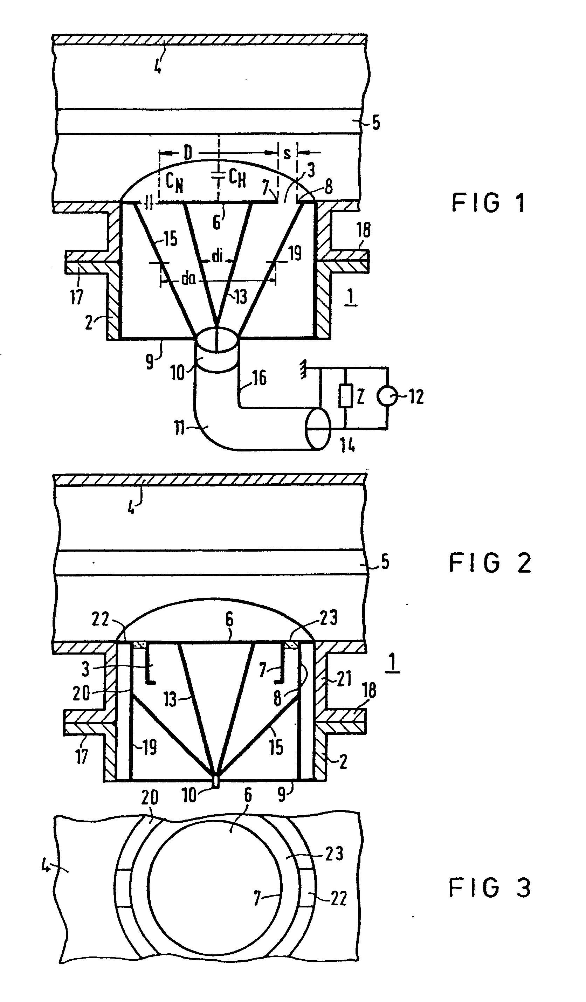

Im folgenden sei die Erfindung noch anhand von in den Fig. 1 bis 3 der Zeichnung dargestellten Ausführungsbeispielen näher erläutert. Die Fig. 1 und 2 zeigen schematisch einen Längsschnitt durch eine gekapselte Hochspannungsleitung mit angeschlossenem Anschlussteil der Messvorrichtung. In der Fig. 3 ist ein Teil einer Aufsicht auf die Innenwand der Kapselung und die dort liegende obere Stirnfläche des Anschlusteiles mit der plattenförmigen Elektrode nach Fig. 2 dargestellt.

Bei einer mit insbesondere mit $SF_6$ druckgasisolierten, metallgekapselten Hochspannungsschaltanlage sollen die bei örtlichen Teilentladungen auftrtenden Spannungsimpulse gemessen werden. Dazu dient die gemäss der Erfindung ausgebildete Messanordnung 1, die mit Hilfe eines Anschlusteiles 2 in eine Öffnung 3 in der metallischen Kapselung 4 angeordnet ist. Die metallische Kapselung 4 besteht aus einem Zylinder, der den Innenleiter 5 koaxial umgibt, entsprechend ist die Öffnung 3 in der Kapselung 4 kreisförmig ausgebildet.

Zur Erfassung der bei örtlichen Teilentladungen auftretenden Spannungsimpulse wird ein kapazitiver Spannungsteiler verwendet. Dieser besteht aus einem Hochspannungskondensator $C_H$, gebildet aus dem Hochspannung führenden Innenleiter 5 und einer diesen koaxial umgebenden plattenförmigen Elektrode 6, die bündig in der Öffnung 3 der Kapselung 4 eingesetzt ist. Die Niederspannungskapazität $C_4$ dieses Spannungsteilers wird von dem Rand 7 der Elektrode 6 und dem gegenüberliegenden Rand 8 der Öffnung 3 der geerdeten Kapselung 4 gebildet. Die Kapazität des Niederspannungskondensators $C_N$ kann über die Spaltbreite s zwischen den Rändern 7 und 8 und dem Durchmesser D der Elektrode 6 frei gewählt werden. Sie ist so bemessen, dass das gewünschte Teilerverhältnis erreicht wird.

Die Elektrode 6 und der Rand 8 der Öffnung 3 der Kapselung 4 sind kontruktiv im Anschlussteil 2 zusammengefasst und bilden dessen innere ebene Sitrnfläche. Der Anschlussteil 2 ist als selbsttragendes Bauteil ausgebildet. An der äusseren Stirnfläche 9 des Anschlusteiles 2 wird über eine koaxial ausgebildete Anschlussbuchse 10 die Verbindung zur koaxialen Messleitung 11 hergestellt, die zu einem Mess- bzw. Anzeigegerät 12 führt. Zwischen der Anschlussbuchse 10 und der Elektrode 6 liegt ein kegelförmiger innerer Verbindungsteil 13, der den Innenleiter 14 der Messleitung 11 mit der Elektrode 6 verbindet. Koaxial dazu ist der äussere Verbindungsteil 15 angeordnet, der als Hohlkegel ausgebildet ist und die Verbindung zwischen dem geerdeten Aussenleiter 16 der Messleitung 11 und dem Rand 8 der Kapselung 4 herstellt. Das Durchmesserverhältnis zwischen dem jeweiligen Durchmesser $d_a$ des äusseren Verbindungsteiles 15 und dem jeweiligen Durchmesser $d_1$ des inneren Verbindungsteiles 13 ist so konstant gewählt, dass die Verbindungsteile 13, 15 den Wellenwiderstand Z der Messleitung 11 aufweisen. Dadurch ist der Anschluss der koaxialen Messleitung 11 an die Niederspannungskapazität $C_N$ reflexionsfrei gestaltet.

Aus Gründen der Gewichtsersparnis sind die beiden Verbindungsteile 13 und 15 als koaxiale Hohlkegel ausgebildet.

Der Anschlussteil 2 der Messvorrichtung 1 ist ausserdem mit einem Befestigungsflansch 17 versehen, dem ein Flansch 18 der Kapselung gegenübersteht. Beide Flansche 17 und 18 werden miteinander druckfest verbunden. Dabei ist ausserdem für eine leitende Anlage der über den Befestigungsflansch 17 hinausragenden Aussenwand 19 des Anschlusteiles 2, die zum Rand 8 der Öffnung 3 der Kapselung 4 führt, an der Begrenzungswand dieser Öffnung 3 durch eine Kontaktierung bündig zur Innenwand der Kapselung gesorgt, so dass eine einwandfreie Potentialanbindung des Randes 8 gewährleistet ist.

Ein leicht abgewandeltes weiteres Ausführungsbeispiel der Erfindung ist in den Fig. 2 und 3 dargestellt. Für gleiche Teile sind die gleichen Bezugszeichen beibehalten.

Hier ist die zum Rand 8 der Kapselung 4 führende Aussenwand 19 des Anschlusteiles 2 räumlich getrennt vom Befestigungsflansch 17 ausgebildet. Entsprechend ergibt sich ein Zwischenraum 20 zwischen der zum Flansch 18 der Kapselung 4 führenden Wand 21 und der Aussenwand 19. Um eine einwandfreie Erdung beider Teile zu erreichen, ohne dass eine Verfälschung des Messergebnisses auftritt, ist deshalb an der Innenwand der Kapselung 4 in axialer Richtung des Innenleiters 5 eine grossflächige leitende Verbindung 22 mit Hilfe eines flexiblen Kupferbandes hergestellt. Es kann auch der gesamte ringförmige Zwischenraum 20 an der Innenwand der Kapselung 4 leitend überbrückt sein.

Bei diesem Ausführungsbeispiel ist ebenfalls zur Versteifung des Anschlusteiles 2 zwischen dem Rand 7 der Elektrode 6 und dem Rand 8 ein Ring 23 aus Isolierstoff angeordnet. Des weiteren ist der Rand 7 der Elektrode 6 flanschartig nach aussen gezogen, um ein anderes Teilverhältnis einstellen zu können. Der Niederspannungskondensator $C_N$ ist dann von diesem flanschartigen Rand 7 und dem gegenüberstehenden oberen Bereich der Aussenwand 19 gebildet, der den Rand 8 darstellt.

Man kann die Auskopplung der durch die Teilentladungen gegebenen Spannungsimpule noch dadurch verbessern, dass in an sich bekannter Weise parallel zum Niederspannungskondensator $C_N$ eine Spule, insbesondere eine Toroidspule, geschaltet wird . Dadurch wird die Betriebsfrequenz der Hochspannung noch stärker unterdrückt, als es ohnehin schon durch die untere Grenzfrequenz der Messvorrichtung, die sich aus dem Wellenwiderstand Z und der Kapazität des Niederspannungskondensators $C_N$ zu

$$\frac{1}{2\pi . Z . C_N}$$ ergibt, der Fall ist.

Wird die Messvorrichtung an mehreren Stellen innerhalb der gekoppelten Hochspannungsschaltanlage eingesetzt, so lässt sich durch die Unterschiede in den Laufzeiten der gemessenen Teil-

entladungsimpulse auch eine angenäherte Lokalisierung der Ursachen für die Teilentladung vornehmen.

## Patentansprüche

1. Messvorrichtung zur Feststellung von Teilentladungen innerhalb metallgekapselter, druckgasisolierter Hochspannungsschaltanlagen mit Hilfe eines kapazitiven Spannungsteilers, dessen Hochspannungskondensator von dem in der Kapselung isoliert abgestützten Innenleiter und einer isoliert mit Abstand in einer Öffnung der Kapselung angeordneten Elektrode und dessen Niederspannungskondensator von der Elektrode und dem Rand der Öffnung in der Kapselung gebildet wird und der über eine Messleitung mit einem Anzeige- und/oder Messgerät verbunden ist, dadurch gekennzeichnet, dass die Elektrode (6) plattenförmig ausgebildet und bündig in die Öffnung (3) der Kapselung (4) eingesetzt ist, dass die Messleitung (11) koaxial ausgebildet ist und mit einem Anschlussteil (2) verbunden ist der als tragendes Bauteil mit einem Befestigungsflansch (17) die Verbindung zur Kapselung (4) herstellt und die Elektrode (6) und den Rand (8) der Öffnung (3) in der Kapselung (4) enthält, dass der Anschlussteil (2) einen zum Rand (8) der Öffnung (3) in der Kapselung (4) geführten äusseren hohlkegelförmigen Verbindungsteil (15) und einen zur Elektrode (6) geführten inneren kegelförmigen Verbindungsteil (13) enthält, die koaxial angeordnet sind, deren Durchmesserverhältnis $d_a/d_i$ konstant ist, und die den Wellenwiderstand (z) der Messleitung (11) aufweisen.

2. Messvorrichtung nach Anspruch 1, dadurch gekennzeichnet, dass der Befestigungsflansch (17) des Anschlussteiles (2) an einem räumlich vom Rand (8) der Öffnung (3) in der Kapselung (4) getrennten Flansch (18) der Kapselung (4) befestigt ist und dass zwischen dem äusseren Verbindungsteil (15) und dem Flansch (18) der Kapselung (4) mindestens zwei leitende Verbindungen (22) vorgesehen sind, die in der axialen Richtung des Innenleiters (5) angeordnet sind und bündig zur Innenwand der Kapselung (4) liegen.

3. Messvorrichtung zur Feststellung von Teilentladungen innerhalb einer metallgekapselten, druckgasisolierten Hochspannungsschaltanlage, bei der die Kapselung einen zum Innenleiter koaxialen Zylinder bildet nach Anspruch 1 oder 2, dadurch gekennzeichnet, dass die Elektrode (6) ein Ausschnitt des Zylinders ist.

4. Messvorrichtung nach Anspruch 1, 2 oder 3, dadurch gekennzeichnet, dass die Elektrode (6) ein kreisförmiger Ausschnitt der Kapselung (4) ist.

5. Messvorrichtung nach Anspruch 1, dadurch gekennzeichnet, dass der äussere und innere Verbindungsteil (15, 13) als gleichachsig angeordnete Hohlkegel ausgebildet sind.

6. Messvorrichtung nach Anspruch 1, dadurch gekennzeichnet, dass der Anschlussteil (2) auf seiner äusseren Stirnfläche (9) eine koaxiale Anschlussbuchse (10) für die Messleitung (11) trägt.

7. Messvorrichtung nach Anspruch 1, dadurch gekennzeichnet, dass der Rand (7) der Elektrode (6) und der gegenüberstehende Rand (8) der Öffnung (3) in der Kapselung (4) flanschartig nach aussen gezogen sind.

8. Messvorrichtung nach Anspruch 2, dadurch gekennzeichnet, dass als leitende Verbindung (22) zwischen dem äusseren Verbindungsteil (15) und der Kapselung (4) flexible Bänder aus leitfähigem Material verwendet sind.

## Claims

1. A measuring device für detecting partial discharges within metal-shielded, pressure gas-isolated high-voltage switch gear with the aid of a capacitive voltage divider, whose high-voltage capacitor is formed by the inner conductor, which is supported so as to be insulated inside the casing, and by an electrode which is arranged at a distance in an opening of the casing so as to be insulated, and whose low-voltage capacitor is formed by the electrode and the edge of the opening in the casing and which is connected to a display and/or measuring apparatus by a measuring line, characterised in that the electrode (6) is planar and flush-mounted in the opening (3) of the casing (4), and in that the measuring line (11) is coaxial and is connected to a connecting component (2) which acts as a supporting component having a fastening flange (17) and forms the connection to the casing (4) and encloses the electrode (6) and the edge (8) of the opening (3) in the casing (4), the connecting component (2) comprising a hollow conical outer connecting component (15), leading to the edge (8) of the opening (3) in the casing (4), and comprises an inner conical connecting component (13) which leads to the electrode (6), the connecting components being coaxially arranged and their diameter ratio $d_a/d_i$ being constant and their surge impedance (z) being that of the measuring line (11).

2. A measuring device as claimed in Claim 1, characterised in that the fastening flange (17) of the connecting component (2) is secured to a flange (18) of the casing (4) which is spaced from the edge (8) of the opening (3) in the casing (4), and that between the outer connecting component (15) and the flange (18) of the casing are arranged at least two conductive connections (22) which are arranged in the axial direction of the inner conductor (5) and are flush with the inside wall of the casing (4).

3. A measuring device for detecting partial discharges within a metal-shielded, pressure gas insulated high-voltage commutator arrangement, wherein the casing is a cylinder coaxial with the inner conductor, as claimed in Claim 1 or 2, characterised in that the electrode (6) is a segment of the cylinder.

4. A measuring device as claimed in Claim 1, 2 or 3, characterised in that the electrode (6) is a circular segment of the casing (4).

5. A measuring device as claimed in Claim 1, characterised in that the outer and inner connecting components (15, 13) are designed as coaxially arranged hollow cones.

6. A measuring device as claimed in Claim 1, characterised in that on its outer end face (9) the connecting component (2) supports a coaxial connecting socket (10) for the measuring line (11).

7. A measuring device as claimed in Claim 1, characterised in that the edge (7) of the electrode (6) and the opposite edge (8) of the opening (3) in the casing (4) extend outwardly in a flange-like manner.

8. A measuring device as claimed in Claim 2, characterised in that the flexible strips consisting of a conductive material are used as conductive connections (22) between the outer connection component (15) and the casing (4).

**Revendications**

1. Dispositif de mesure pour détecter des décharges partielles dans des appareillages haute tension à blindage métallique et à isolation par un gaz sous pression, à l'aide d'un diviseur de tension capacitif dont le condensateur haute tension est formé par le conducteur intérieur soutenu avec isolation dans le blindage et par une électrode disposée de façon isolée et à distance dans une ouverture du blindage, et dont le condensateur basse tension est formé par l'électrode et par le bord de l'ouverture ménagé dans le blindage et est reliée, par l'intermédiaire d'un câble de mesure, à un appareil d'affichage et/ou de mesure, caractérisé par le fait que le câble de mesure (11) est un câble coaxial et est relié à une pièce de raccordement (2) qui, en tant qu'élément portant, établit à l'aide d'une bride de fixation (17) la liaison avec le blindage (4), et comporte l'électrode (6) et le bord (8) de l'ouverture (3) ménagée dans le blindage (4); que la pièce de raccordement (2) comporte une pièce de liaison (15) extérieure de la forme d'un cône creux menant vers le bord (8) de l'ouverture ménagée dans le blindage (4), et une pièce de liaison intérieure (13) de la forme d'un cône creux menant à l'électrode (6), lesdites pièces de liaison étant disposées coaxialement, le rapport de leurs diamètres $d_a/d_i$ étant constant, et représentant l'impédance caractéristique (7) du câble de mesure (11).

2. Dispositif de mesure suivant la revendication 1, caractérisé par le fait que la bride de fixation (17) de la pièce de raccordement (2) est fixée à une bride (18) du blindage, séparée spatialement du bord (8) de l'ouverture (3) ménagée dans le blindage (4), et qu'entre la pièce de liaison extérieure (15) et la bride (18) du blindage (4) sont prévues au moins deux liaisons conductrices (22) qui sont disposées dans le sens axial du conducteur intérieur (5) et se situent au niveau de la paroi intérieure du blindage.

3. Dispositif de mesure pour détecter des décharges partielles dans des appareillages haute tension à blindage métallique et à isolation par un gaz sous pression, dans lequel le blindage forme un cylindre coaxial au conducteur intérieur, selon la revendication 1 ou 2, caractérisé par le fait que l'électrode (6) est une portion de cylindre.

4. Dispositif de mesure selon la revendication 1, 2, ou 3, caractérisé par le fait que l'électrode (6) est une portion circulaire du blindage (4).

5. Dispositif de mesure selon la revendication 1, caractérisé par le fait que les pièces de liaison extérieure et intérieure (15, 13) sont réalisées sous la forme de cônes creux disposés coaxialement.

6. Dispositif de mesure selon la revendication 1, caractérisé par le fait que la pièce de raccordement (2) porte sur sa surface frontale extérieure (9) une douille coaxiale de raccordement (10) pour le câble de mesure (11).

7. Dispositif de mesure selon la revendication 1, caractérisé par le fait que le bord (7) de l'électrode (6) et le bord opposé (8) de l'ouverture ménagée dans le blindage (4) s'étendent vers l'extérieur à la manière de brides.

8. Dispositif de mesure selon la revendication 2, caractérisé par le fait qu'on utilise, comme liaison conductrice (22) entre la pièce de liaison extérieure (15) et le blindage, des rubans flexibles en un matériau conducteur.

FIG 1

FIG 2

FIG 3